# EUROPÄISCHE PATENTSCHRIFT

(11) **EP 3 246 715 B1**
(45) Veröffentlichungstag und Bekanntmachung des Hinweises auf die Patenterteilung: **05.06.2019**
(21) Anmeldenummer: 17164670.6
(22) Anmeldetag: 04.04.2017
(51) Int. Cl.: G01R 27/18, G01R 35/00

(54) **VERFAHREN UND VORRICHTUNGEN ZUR FUNKTIONSPRÜFUNG EINES ISOLATIONSÜBERWACHUNGSGERÄTES**
METHODS AND DEVICES FOR TESTING THE FUNCTIONALITY OF AN INSULATION MONITORING DEVICE
PROCÉDÉS ET DISPOSITIFS DE CONTRÔLE FONCTIONNEL D'UN APPAREIL DE SURVEILLANCE D'ISOLATION

(30) Priorität: 27.04.2016 DE 102016207197
(43) Veröffentlichungstag der Anmeldung: 22.11.2017
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- DE-A1- 2 235 602
- Gossen Metrawatt: "Bedienungsanleitung, Serie PROFITEST MASTER, PROFITEST MBASE+, MTECH+, MPRO, MXTRA, SECULIFE IP, Prüfgeräte DIN VDE 0100", , 29. April 2015 (2015-04-29), XP002774061, Gefunden im Internet: URL:https://web.archive.org/web/2015042921 1906/https://gossenmetrawatt.com/resources /p1/profitestmaster/ba_d.pdf [gefunden am 2017-09-25]

## Beschreibung

Die Erfindung betrifft Verfahren und Vorrichtungen zur Funktionsprüfung eines in einem ungeerdeten Stromversorgungssystem installierten, normgerechten Isolationsüberwachungsgerätes während des Betriebs.

Für die Versorgung von elektrischen Betriebsmitteln kommt bei erhöhten Anforderungen an die Betriebs-, Brand- und Berührungssicherheit die Netzform eines ungeerdeten (IT-)Stromversorgungssystems (frz. Isolé Terre) zum Einsatz. Bei dieser Art des Stromversorgungssystems sind die aktiven Teile der elektrischen Anlage von dem Erdpotential getrennt.

Durch die inhärente Sicherheit des ungeerdeten Stromversorgungssystems kann somit eine kontinuierliche Stromversorgung der von dem ungeerdeten Stromversorgungssystem gespeisten Verbraucher, d.h. der an das ungeerdete Stromversorgungssystem angeschlossenen Betriebsmittel, auch dann gewährleistet werden, wenn ein erster Isolationsfehler auftritt.

Dies setzt voraus, dass der Widerstand in dem zu überwachenden Netz von aktiven Leitern des Stromversorgungssystems gegen Erde (Isolationswiderstand - im Fehlerfall auch Isolationsfehlerwiderstand oder Fehlerwiderstand) ständig überwacht werden muss, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Zur Isolationsüberwachung ungeerdeter Stromversorgungssysteme werden Isolationsüberwachungsgeräte (IMDs - Insulation Monitoring Devices) eingesetzt, deren Anforderungen in der internationalen Norm IEC 61557-8 festgelegt sind.

Allerdings existieren auch Anwendungsfälle, insbesondere in Verbindung mit dem Einsatz von Stromrichtern im Megawatt-Leistungsbereich, in denen bereits bei einem ersten Fehler hohe Fehlerströme über Pfade fließen können, die nicht für derart hohe Stromstärken ausgelegt sind. Dadurch können personen- und anlagengefährdende Betriebszustände entstehen, sodass eine automatische Abschaltung der Stromversorgung bereits in dem ersten Fehlerfall durchzuführen ist. Die Abschaltung des Stromversorgungssystems wird dabei von dem Isolationsüberwachungsgerät mittels eines Abschaltsignals an dessen Alarmausgang ausgelöst.

Aus diesen Betrachtungen geht hervor, dass in den vorgenannten Anwendungsfällen an den Einsatz eines Isolationsüberwachungsgerätes erhöhte Zuverlässigkeitsanforderungen zu stellen sind. Ähnlich wie bei bekannten Schutzeinrichtungen, beispielsweise bei Fehlerstrom-Schutzeinrichtungen (RCDs), ist eine regelmäßig wiederkehrende Überprüfung der Funktion des Isolationsüberwachungsgerätes erforderlich, um zu gewährleisten, dass die Abschaltung im Fehlerfall zuverlässig funktioniert.

Eine wiederkehrende Überprüfung des Isolationsüberwachungsgerätes erfolgt derzeit oftmals nur im Rahmen einer vorgeschriebenen Wiederholungsprüfung des Stromversorgungssystems, meist teilautomatisiert unter Verwendung eines Installationsprüfgerätes oder einer (selbstgefertigten) Prüfvorrichtung, beispielsweise eines per Relais geschalteten Prüf-Fehlerwiderstands.

Aus dem Stand der Technik bekannte Installationsprüfgeräte, beispielsweise der Firma Benning [http://www.kometec.de/shop/pdf/viabnbaitl 10it120.pdf (DE), http://www.energeia.gr/files/manuals/IT120.pdf (EN) oder der Firma Gossen-Metrawatt http://gossenmetrawatt.com/gmc/resources/p1/profitestmaster_mpro-mxtra/ba_d.pdf (DE), http://gossenmetrawatt.com/resources/p1/profitestmaster/ba_gb.pdf (EN)],
oder Gossen Metrawatt. Bedienungsanleitung, Serie PROFITEST MASTER, PROFITEST MBASE+, MTECH+, MPRO, MXTRA, SECULIFE IP, Prüfgeräte DIN VDE 0100, 29.04 2015, https://web.archive.org/web/20150429211906/https://gossenmetrawatt.com/resources/p1/ profitestmaster/ba_d.pdf [abgerufen am 25.09.2017], schalten temporär einen Fehlerwiderstand von einem aktiven Leiter gegen Erde und protokollieren das Verhalten des zu prüfenden Isolationsüberwachungsgeräts. Allerdings muss auch hier der Prüfvorgang durch manuelle Eingaben des Benutzers veranlasst und begleitet werden. Zudem sind die Installationsprüfgeräte für die teilautomatisierte Prüfung von Isolationsüberwachungsgeräten meist nicht für Stromversorgungssysteme mit Nennspannungen über 400 V geeignet und berücksichtigen nur unzureichend den speziellen Anwendungsfall.

Bei einer rein manuell durchgeführten Prüfung des Isolationsüberwachungsgerätes schaltet das Bedienpersonal entweder in dem unter Spannung stehenden Stromversorgungssystem einen geeigneten Fehlerwiderstand von einem aktiven Leiter gegen Erde oder die Anlage muss zur Prüfung mehrfach herunter- und wieder hochgefahren werden, um die Fehlerwiderstände gefahrlos zu- und wegschalten zu können. Diese Vorgehensweisen sind entweder sehr gefährlich für das Personal oder so aufwändig in der Durchführung, dass eine Prüfung unterbleibt.

Eine weitere Gefahrenquelle stellen in der Praxis eingesetzte, von dem Anlagenbetreiber selbstkonstruierte oder fremdbezogene, einfache teilautomatisierte Prüfvorrichtungen dar. Diese Prüfvorrichtung bestehen meist aus den Elementen Prüfwiderstand, elektromechanischem Schalter (Relais, Schütz) und einem Schalter oder Taster.

Erfolgt die Zuschaltung des Prüffehlerwiderstandes über eine Prüftaste, so muss dieser Taster je nach Art der Anlage, Betriebszustand und zum Einsatz kommendem Isolationsüberwachungsgerät über einen hinreichend langen Zeitraum in gedrückter Stellung gehalten werden. Aufgrund dieses Erfordernisses ist man vielfach geneigt, statt eines Tasters einen Schalter vorzusehen, der seinen Schaltzustand beibehält und den Prüf-fehlerwiderstand von den aktiven Leitern gegen Erde schaltet, solange der Schalter nicht zurückgestellt wird. Diese Lösungen sind potentiell gefährlich, da das Risiko besteht, dass der Schalter nicht oder nicht rechtzeitig erneut betätigt wird, um den Prüf-Fehlerwiderstand wegzuschalten. Das Stromversorgungssystem würde dann zu lange oder gar dauerhaft mit einem ersten Fehler betrieben werden. Ist die verwendete Prüfvorrichtung nicht für die dabei auftretenden Überspannungen ausgelegt, kann es in diesem Dauerprüfbetrieb zu Personen- und Sachschäden durch Brandgefahren kommen.

Eine Produktnorm für teilautomatische festeingebaute Prüfeinrichtungen zur Überprüfung der Funktion des Isolationsüberwachungsgerätes existiert nicht, daher muss der Betreiber beim Einsatz von diesen Lösungen eigenverantwortlich eine Risikoabwägung durchführen.

Bei dem Einsatz einer selbstgefertigten oder fremdbezogenen, teilautomatischen festeingebauten Prüfeinrichtung - welche immer noch eine manuelle Bedienung erfordert - ist es nur mit sehr großem Aufwand möglich, eine Prüfung in so vielen verschiedenen Betriebszuständen der Anlage durchzuführen, dass eine hinreichend begründete Aussage über die zuverlässige Funktion des Isolationsüberwachungsgerätes getroffen werden kann.

In den meisten Anwendungsfällen wird daher auf eine Funktionsüberprüfung des Isolationsüberwachungsgerätes durch externes Einbringen eines Fehlerwiderstandes in der Anlage verzichtet.

Als weiterer Nachteil sowohl bei der Verwendung von Installationsprüfgeräten als auch bei einer rein manuellen Durchführung der Prüfung erweist sich, dass eine Prüfung nur in einem genau zum Prüfzeitpunkt vorherrschenden Betriebszustand des zu überwachenden Stromversorgungssystems erfolgt. Eine Aussage über die Zuverlässigkeit der Überwachung in anderen Systemzuständen ist nur mit deutlich erhöhtem Prüfaufwand möglich.

Als Ersatzmaßnahme wird die Funktionsfähigkeit des Isolationsüberwachungsgerätes mittels eines Selbsttests durch manuelles Betätigen der Prüftaste an dem Isolationsüberwachungsgerät überprüft. Über diese geräteinterne Prüfung werden Ausfälle von Funktionsgruppen im Isolationsüberwachungsgerät erkannt. In einigen Geräten ist auch einstellbar, dass im Rahmen des manuell gestarteten Selbsttests die Alarmrelais anziehen, um die Schaltfähigkeit nachzuweisen.

Ein Teil der bei einem manuellen Selbsttest ausgeführten Prüfungen wird in einigen Isolationsüberwachungsgeräten auch automatisch wiederholt, beispielsweise alle 24 h, durchgeführt. In diesen Geräten sind dann meist gesonderte Alarmausgänge für Gerätefehler vorhanden.

Durch die eingebaute Selbsttestfunktion kann aber nicht überprüft werden, ob systembedingt zwischen dem überwachten ungeerdeten Stromversorgungssystem und Erde vorhandene Störspannungskomponenten die Isolationsüberwachung so stark beeinflussen, dass die Überwachungsaufgabe nicht hinreichend zuverlässig ausgeführt werden kann.

Es lässt sich somit festhalten, dass eine wirtschaftlich vertretbare Lösung zur Überprüfung, ob ein Isolationsüberwachungsgerät in allen Betriebszuständen unter Berücksichtigung der besonderen Anwendung die Überwachungsfunktion hinreichend erfüllt, bisher nicht existiert. Es besteht die Gefahr, dass, insbesondere unter einem aus der Anwendung hervorgehenden Kostendruck, Isolationsüberwachungsgeräte zum Einsatz kommen, die erhebliche Überwachungslücken aufweisen.

Der vorliegenden Erfindung liegt somit die Aufgabe zu Grunde, ein Verfahren und eine Prüfvorrichtung zur Funktionsprüfung eines in einem ungeerdeten Stromversorgungssystem installierten, normgerechten Isolationsüberwachungsgerätes vorzuschlagen, wobei die anwendungsbezogenen Betriebsbedingungen des Isolationsüberwachungsgerätes automatisch berücksichtigt werden, sodass eine umfassende Aussage über die Zuverlässigkeit der Funktion des Isolationsüberwachungsgerätes möglich ist.

Diese Aufgabe wird mit einem ersten erfindungsgemäßen Verfahren nach Anspruch 1 gelöst.

Der Grundgedanke des Verfahrens beruht darauf, in einem ungeerdeten Stromversorgungssystem, das vorschriftsgemäß mit einem Isolationsüberwachungsgerät überwacht wird, zwischen die aktiven Leiter des ungeerdeten Stromversorgungssystems und Erde eine Prüfvorrichtung zu schalten, welche vollautomatisiert in kontinuierlich sich wiederholenden Prüfzyklen einen Isolationswiderstand des ungeerdeten Stromversorgungssystems gezielt verändert und die Reaktion des Isolationsüberwachungsgerätes beobachtet. Die Überprüfung erfolgt kontinuierlich währen des laufenden Betriebs des Stromversorgungssystems, wobei der zeitliche Abstand, in dem eine Wiederholung des Prüfzyklus durchgeführt wird, variabel ist. Das Ergebnis der Prüfung kann protokolliert werden, über Schnittstellen zu einem übergeordneten System gesendet werden oder bei Vorliegen einer vermuteten Fehlfunktion des Isolationsüberwachungsgerätes zu einer Alarmmeldung führen. In kritischen Fällen kann sogar eine Abschaltung der Stromversorgung erwogen werden, um Gefährdungen zu vermeiden.

Bei einem Verfahren wird der augenblickliche Betriebszustand (Isolationsniveau, Lastzustand) des Stromversorgungssystems über Netzparameter wie Isolationswiderstand und Netzableitkapazitäten erfasst und zur Beurteilung der Funktionsfähigkeit des Isolationsüberwachungsgerätes herangezogen.

Eine Gefährdung des Bedienpersonals, wie sie bei manuell durchgeführten Wiederholungsprüfungen oder durch sicherheitstechnisch bedenkliche selbstkonstruierte oder fremdbezogene Prüfeinrichtungen, die keiner Produktnorm unterliegen, entstehen kann, wird durch das erfindungsgemäße Verfahren vermieden.

Bei diesem einen Verfahren wird davon ausgegangen, dass das zu überprüfende Isolationsüberwachungsgerät und die das Isolationsüberwachungsgerät kontrollierende Prüfvorrichtung miteinander kommunizieren, dass also eine Datenübertragung zwischen diesen beiden Geräten stattfindet.

Zunächst erfolgt eine Messung eines ersten Isolationswiderstands des ungeerdeten Stromversorgungssystems durch das Isolationsüberwachungsgerät.

Dieser erste Messwert des Isolationswiderstands wird an die Prüfvorrichtung übermittelt und dort gespeichert.

Ausgehend von dem ersten Isolationswiderstandswert und unter Berücksichtigung weiterer Parameter wie beispielsweise Netz-Nennspannung, Netzableitkapazität, Ansprechwert- und Ansprechzeit berechnet die Prüfvorrichtung einen unkritischen Prüf-Fehlerwiderstandswert. Die weiteren Parameter können dabei zusammen mit dem ersten Isolationswiderstandswert an die Prüfvorrichtung übertragen werden und/oder werden separat in dieser abgelegt. Der unkritische Prüf-Fehlerwiderstandswert stellt einen an die augenblicklichen Betriebsbedingungen des Stromversorgungssystems angepassten Widerstandswert dar, der - in Parallelschaltung mit dem ersten Isolationswiderstandswert - nicht zur Auslösung einer Alarmmeldung durch das Isolationsüberwachungsgerät führen sollte.

Ein Prüf-Fehlerwiderstand mit diesem unkritischen Widerstandswert wird dann durch die Prüfvorrichtung zwischen mindestens einen der aktiven Leiter des ungeerdeten Stromversorgungssystems und Erde geschaltet und liegt damit parallel zu dem zuvor gemessenen ersten Isolationswiderstand.

Anschließend wird durch das Isolationsüberwachungsgerät ein zweiter Isolationswiderstand des ungeerdeten Stromversorgungssystems gemessen, der sich ergibt aus dem ersten Isolationswiderstand und dem parallel zugeschalteten Prüf-Fehlerwiderstand.

Dieser zweite Isolationswiderstandswert wird ebenfalls an die Prüfvorrichtung übermittelt, dort gespeichert und mit einem von der Prüfvorrichtung aus dem ersten Isolationswiderstandswert und dem parallel zugeschalteten Prüf-Fehlerwiderstandswert berechneten Vergleichs-Isolationswiderstandswert verglichen. Das Vergleichsergebnis wird in einem Ergebnisprotokoll dokumentiert und kann bei Bedarf über eine geeignete Kommunikationsschnittstelle ausgelesen und übertragen werden.

Falls der Vergleich ergibt, dass der von dem Isolationsüberwachungsgerät gemessene zweite Isolationswiderstand eine Abweichung von dem berechneten Vergleichs-Isolationswiderstandswert aufweist, die auf eine Fehlfunktion des Isolationsüberwachungsgerätes schließen lässt, aktiviert die Prüfvorrichtung eine Alarmmeldung.

Mit dem Wegschalten des Prüf-Fehlerwiderstands durch die Prüfvorrichtung wird der aktuelle Prüfzyklus beendet und nach einer voreinstellbaren Zeit eine Wiederholung des Prüfzyklus gestartet.

Eine Ausgestaltung dieses einen Verfahrens betrifft eine Anordnung, bei der die Prüfvorrichtung funktionaler Bestandteil eines weiteren Isolationsüberwachungsgerätes ist. In diesem Fall kann dieses weitere Isolationsüberwachungsgerät bei Auftreten einer Fehlfunktion des bereits installierten Isolationsüberwachungsgerätes die Aufgabe der Isolationsüberwachung in dem ungeerdeten Stromversorgungssystem übernehmen. Eine weitere Ausgestaltung des Verfahrens ist dann anwendbar, falls die Prüfvorrichtung funktionaler Bestandteil eines weiteren Isolationsüberwachungsgerätes ist und das bereits installierte Isolationsüberwachungsgerät ebenfalls eine Prüfvorrichtung als funktionalen Bestandteil umfasst. Somit sind zwei funktional gleichwertige Isolationsüberwachungsgeräte in Betrieb, die jeweils neben ihrer Isolationsüberwachungsfunktion eine Prüfvorrichtung aufweisen.

In diesem Fall können die beiden Isolationsüberwachungsgeräte wechselweise die Aufgabe der Isolationsüberwachung und die Aufgabe der Funktionsprüfung des jeweils anderen Installationsüberwachungsgerätes übernehmen. Wird das bereits installierte Isolationsüberwachungsgerät von der Prüfvorrichtung des weiteren Isolationsüberwachungsgerätes als unzuverlässig beurteilt, so erfolgt ein Wechsel der Gerätefunktion in der Weise, dass das weitere Isolationsüberwachungsgerät die Isolationsüberwachung übernimmt und von der Prüfvorrichtung des bereits installierten Isolationsüberwachungsgerätes kontrolliert wird. Auf diese Weise kann auch bei einer Fehlfunktion des bereits installierten Isolationsüberwachungsgerätes die Anlage bei Unterschreiten eines kritischen Isolationswiderstandsniveaus durch das weitere Isolationsüberwachungsgerät in einen sicheren Betriebszustand gefahren werden.

Der Wechsel der Gerätefunktion kann dabei zentral von einem kontrollierendem Leitsystem oder, falls kein übergeordnetes Leitsystem existiert, über einen in beiden Geräten synchron laufenden Timer erfolgen.

Weiterhin wird die Aufgabe mit einem zweiten erfindungsgemäßen Verfahren nach Anspruch 4 gelöst.

Der diesem Verfahren zugrunde liegende Gedanke beruht ebenfalls wie bei dem ersten Verfahren darauf, in einem mit einem Isolationsüberwachungsgerät vorschriftsgemäß überwachten ungeerdeten Stromversorgungssystem eine Prüfvorrichtung zwischen die aktiven Leiter des ungeerdeten Stromversorgungssystems und Erde zu schalten, welche vollautomatisiert in kontinuierlich sich wiederholenden Prüfzyklen einen Isolationswiderstand des ungeerdeten Stromversorgungssystems gezielt verändert und die Reaktion des Isolationsüberwachungsgerätes beobachtet. Allerdings wird bei einem zweiten Verfahren davon ausgegangen, dass das zu überprüfende Isolationsüberwachungsgerät und die das Isolationsüberwachungsgerät kontrollierende Prüfvorrichtung nicht miteinander kommunizieren, dass also keine Datenübertragung zwischen diesen beiden Geräten stattfindet.

Der Prüfvorrichtung müssen daher die zur Bewertung der Funktionsfähigkeit des Isolationsüberwachungsgerätes erforderlichen aktuellen Parameter des Isolationsüberwachungsgerätes und des Stromversorgungssystems bekannt sein.

Dazu werden ein Innenwiderstandswert des Isolationsüberwachungsgeräts, ein in dem Isolationsüberwachungsgerät eingestellter Ansprechwert für den Isolationswiderstand und eine in dem Isolationsüberwachungsgerät eingestellte maximal zulässige Ansprechzeit in der Prüfvorrichtung hinterlegt.

In einem ersten Schritt des Prüfzyklus misst die Prüfvorrichtung einen wirksamen Isolationswiderstand, der sich ergibt aus dem Innenwiderstand des aktiven Isolationsüberwachungsgeräts und einem parallel dazu liegenden Isolationswiderstand des ungeerdeten Stromversorgungssystems.

Aus dem gemessenen wirksamen Isolationswiderstandswert und dem hinterlegten Innenwiderstandswert des Isolationsüberwachungsgeräts berechnet die Prüfvorrichtung einen Isolationswiderstandswert des ungeerdeten Stromversorgungssystems, auf dessen Basis ein kritischer Prüf-Fehlerwiderstandswert berechnet werden kann. Dieser kritische Prüf-Fehlerwiderstandswert ist so bemessen, dass er unter Berücksichtigung des bekannten Ansprechwertes eine System-Alarmmeldung in dem Isolationsüberwachungsgerät auslösen soll.

Der Prüf-Fehlerwiderstand wird durch die Prüfvorrichtung zwischen mindestens einen der aktiven Leiter des ungeerdeten Stromversorgungssystems und Erde geschaltet, gleichzeitig eine Zeitmesseinrichtung zur Messung einer Ansprechzeit des Isolationsüberwachungsgerätes gestartet und ein System-Alarmausgang des Isolationsüberwachungsgerätes durch die Prüfvorrichtung überwacht.

Falls über den System-Alarmausgang kein erwarteter Alarm signalisiert wurde und die gemessene Ansprechzeit die maximal zulässige Ansprechzeit überschreitet, startet die Prüfvorrichtung eine Fehlerbehandlung.

Wird ein Alarm innerhalb der maximal zulässigen Ansprechzeit an dem System-Alarmausgang signalisiert, so wird dies in Form eines Ergebnisprotokolls und/oder durch Übertragen des Prüfungsergebnisses an ein Leitsystem festgehalten.

Abgeschlossen wird der Prüfzyklus durch Wegschalten des Prüf-Fehlerwiderstands.

In weiterer Ausgestaltung des Verfahrens werden bei einer Überschreitung der maximal zulässigen Ansprechzeit als Fehlerbehandlung eine oder mehrere der folgenden Aktionen durch die Prüfvorrichtung ausgeführt: Protokollieren des Fehlers, Übermitteln einer Fehlermeldung an ein übergeordnetes Leitsystem, Ausgeben einer - vorzugsweise optischen und/oder akustischen Funktions-Alarmmeldung.

Da das zweite Verfahren zwingend die Auslösung eines Systemalarms des Isolationsüberwachungsgerätes voraussetzt, um dessen Funktionsfähigkeit zu bewerten, ist es erforderlich, einen tatsächlichen Systemalarm des Isolationsüberwachungsgerätes von einem prüfungsbedingten Systemalarm des Isolationsüberwachungsgerätes unterscheiden zu können. Es erfolgt daher die Bereitstellung eines wirksamen Systemalarms durch eine Entkopplung des System-Alarmausgangs des Isolationsüberwachungsgerätes in der Weise, dass der von dem Isolationsüberwachungsgerät ausgelöste Systemalarm nur wirksam wird, falls der von dem Isolationsüberwachungsgerät ausgelöste Systemalarm nicht durch einen Prüfzyklus bewirkt wurde.

Die der Erfindung zugrunde liegende Aufgabe wird weiterhin mit einer Prüfvorrichtung nach Anspruch 7 gelöst, welche das erste erfindungsgemäße Verfahren ausführt.

Dazu weist eine Prüfvorrichtung eine Steuer- und Recheneinheit mit einer Speichereinrichtung zum Ausführen des vollautomatisiert, kontinuierlich ablaufenden Prüfungszyklus auf. Die Steuer- und Recheneinheit steuert den Ablauf der Verfahrensschritte in dem Prüfzyklus und führt die Berechnungen aus.

Eine Kommunikationseinrichtung dient der Datenübertragung, wobei eine Datenverbindung zu dem Isolationsüberwachungsgerät vorgesehen ist und eine Kommunikation mit einem übergeordneten Leitsystem möglich sein kann. Über den zwischen dem Isolationsüberwachungsgerät und der Prüfvorrichtung errichteten Kommunikationskanal werden dem Ablauf des Prüfzyklus entsprechende Aktionen auch auf dem Isolationsüberwachungsgerät ausgelöst. Die Kommunikationseinrichtung kann ebenfalls die Bereitstellung eines Prüf-Alarmsignals umfassen.

Eine Schalteinrichtung ermöglicht das Schalten des Prüf-Fehlerwiderstands zwischen mindestens einen aktiven Leiter des ungeerdeten Stromversorgungssystems und Erde.

Mit einer Prüfalarmeinrichtung wird im Falle einer festgestellten Fehlfunktion des Isolationsüberwachungsgerätes eine Alarmmeldung aktiviert.

Die der Erfindung zugrunde liegende Aufgabe wird weiterhin mit einer Prüfvorrichtung nach Anspruch 8 gelöst, welche das zweite erfindungsgemäße Verfahren ausführt.

Auch in dieser Ausführung weist eine Prüfvorrichtung eine Steuer- und Recheneinheit mit einer Speichereinrichtung zum Ausführen des vollautomatisiert, kontinuierlich ablaufenden Prüfungszyklus auf. Da zwischen dem Isolationsüberwachungsgerät und der Prüfvorrichtung keine direkte Kommunikation stattfindet - eine indirekte Kommunikation über ein übergeordnetes Leitsystem kann aber vorgesehen sein -, betreffen die während des Ablaufs des Prüfzyklus ausgeführten Aktionen lediglich die Prüfvorrichtung selber.

Weiterhin weist eine Prüfvorrichtung in dieser Ausführung eine Messeinrichtung zum Messen des in dem ungeerdeten Stromversorgungssystem wirksamen Isolationswiderstands auf. Im Gegensatz zu der das erste Verfahren ausführenden Prüfvorrichtung führt eine Prüfvorrichtung in dieser Ausführung selbst eine Messung des (wirksamen) Isolationswiderstands aus, um auf Grundlage des wirksamen Isolationswiderstandswertes den kritischen Prüf-Fehlerwiderstandswert zu bestimmen.

Eine Schalteinrichtung ermöglicht das Zu- und Wegschalten des Prüf-Fehlerwiderstands zwischen mindestens einen aktiven Leiter des ungeerdeten Stromversorgungssystems und Erde.

Weiterhin weist eine Prüfvorrichtung in dieser Ausführung einen Überwachungseingang zum Überwachen eines System-Alarmausgangs des Isolationsüberwachungsgerätes auf. Mit Hilfe des Überwachungseingangs kann in Verknüpfung mit dem System-Alarmausgang des Isolationsüberwachungsgerätes sichergestellt werden, dass der von dem Isolationsüberwachungsgerät ausgelöste Systemalarm nur wirksam wird, falls der von dem Isolationsüberwachungsgerät ausgelöste Systemalarm nicht durch einen Prüfzyklus bewirkt wurde.

Die der Erfindung zugrunde liegende Aufgabe wird weiterhin gelöst mit einem Isolationsüberwachungsgerät zur Überwachung eines Isolationswiderstands eines ungeerdeten Stromversorgungssystems, welches eine Prüfvorrichtung nach Anspruch 7 oder nach Anspruch 8 aufweist.

In vorteilhafterweise kann der Funktionsumfang eines den Anforderungen der internationalen Norm IEC 61557-8 entsprechenden Isolationsüberwachungsgerätes durch die Integration einer der erfindungsgemäßen Prüfvorrichtungen nach Anspruch 7 oder nach Anspruch 8 erweitert werden. Die Prüfvorrichtung stellt dabei einen funktionalen Block innerhalb des normgerechten Isolationsüberwachungsgerätes dar, sodass der Anlagenbetreiber keine gesonderte Risikobetrachtung über die potentiellen Auswirkungen eines zusätzlich eingebrachten (Prüf-)Fehlerwiderstandes durchführen muss.

Besonders vorteilhaft erweist sich der parallele Einsatz von zwei mit der Prüffunktion erweiterten Isolationsüberwachungsgeräten in dem ungeerdeten Stromversorgungssystem, da diese Geräte wechselweise die Aufgabe der Isolationsüberwachung und die Aufgabe der Funktionsprüfung des jeweils anderen Gerätes übernehmen können.

Durch den Einsatz eines normkonformen Isolationsüberwachungsgerätes mit Prüffunktion werden der Aufwand für eine Risikobewertung bei dem Einsatz einer nicht normgemäßen Prüfeinrichtung und der Aufwand für deren technische Abnahme vermieden.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:
- **Fig. 1a, 1b:**: ein Ablaufdiagramm des ersten erfindungsgemäßen Verfahrens,
- **Fig. 2a, 2b:**: ein Ablaufdiagramm des zweiten erfindungsgemäßen Verfahrens und
- **Fig. 3a bis 3c:**: Anordnungen der Entkopplung des System-Alarmausgangs des Isolationsüberwachungsgerätes.

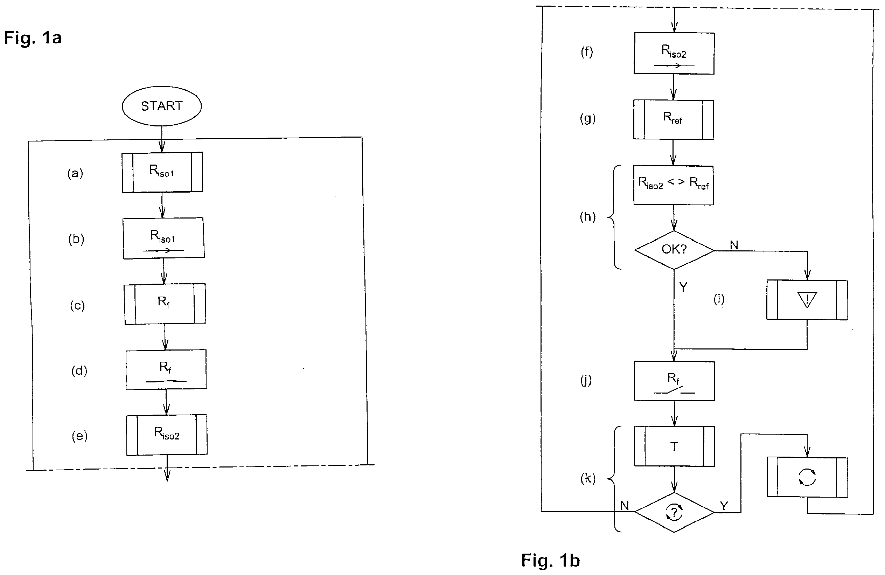

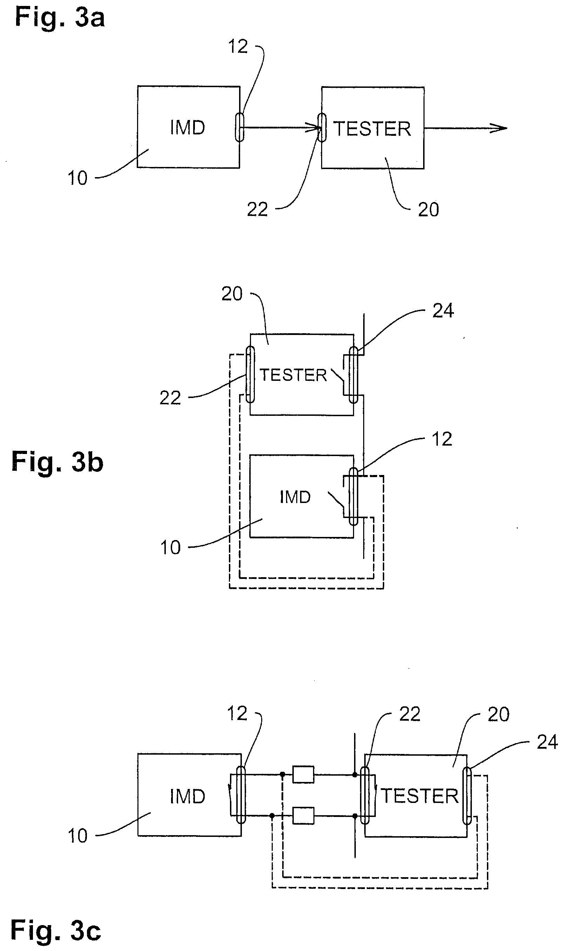

Die **Fig. 1a** und **1b** zeigen ein Ablaufdiagramm des ersten erfindungsgemäßen Verfahrens, welches sich dadurch auszeichnet, dass zwischen dem zu überprüfenden Isolationsüberwachungsgerät 10 (Fig. 3a bis 3c) und der das Isolationsüberwachungsgerät kontrollierenden Prüfvorrichtung 20 (Fig. 3a bis 3c) eine Datenübertragung stattfindet.

Im Einzelnen werden die folgenden Verfahrensschritte ausgeführt:
(a) Messen eines ersten Isolationswiderstands Riso1 des ungeerdeten Stromversorgungssystems durch das Isolationsüberwachungsgerät 10,
(b) Übermitteln des ersten Isolationswiderstandswertes an die Prüfvorrichtung und Speichern des ersten Isolationswiderstandswertes Riso1 in der Prüfvorrichtung 20,
(c) Berechnen eines unkritischen Prüf-Fehlerwiderstandswertes Rf durch die Prüfvorrichtung 20,
(d) Zuschalten des unkritischen Prüf-Fehlerwiderstands Rf zwischen mindestens einen der aktiven Leiter des ungeerdeten Stromversorgungssystems und Erde durch die Prüfvorrichtung 20,
(e) Messen eines zweiten Isolationswiderstands Riso2 des ungeerdeten Stromversorgungssystems, der sich ergibt aus dem ersten Isolationswiderstand Riso1 und dem parallel zugeschalteten Prüf-Fehlerwiderstand Rf, durch das Isolationsüberwachungsgerät 10,
(f) Übermitteln des zweiten Isolationswiderstandswertes Riso2 an die Prüfvorrichtung 20 und Speichern des zweiten Isolationswiderstandswertes Riso2 in der Prüfvorrichtung 20,
(g) Berechnen eines Vergleichs-Isolationswiderstandswertes Rref aus dem ersten Isolationswiderstandswert Riso1 und dem parallel zugeschalteten Prüf-Fehlerwiderstandswert Rf durch die Prüfvorrichtung 20,
(h) Vergleichen des durch das Isolationsüberwachungsgerät 10 gemessenen zweiten Isolationswiderstands Riso2 mit dem durch die Prüfvorrichtung 20 berechneten Vergleichs-Isolationswiderstandswert Rref in der Prüfvorrichtung 20 und Erstellen eines Ergebnisprotokolls,
(i) Aktivieren einer Alarmmeldung durch die Prüfvorrichtung 20, falls der Vergleich ergibt, dass der von dem Isolationsüberwachungsgerät 10 gemessene zweite Isolationswiderstand Riso2 eine Abweichung von dem berechneten Vergleichs-Isolationswiderstandswert Rref aufweist, die auf eine Fehlfunktion des Isolationsüberwachungsgerätes 10 schließen lässt,
(j) Wegschalten des Prüf-Fehlerwiderstands Rf durch die Prüfvorrichtung 20.

In erweiterter Ausgestaltung wird davon ausgegangen, dass zwei Isolationsüberwachungsgeräte (10) mit der Prüffunktion - zur Funktionsprüfung des jeweils anderen Isolationsüberwachungsgerätes (10) - ausgestattet sind, sodass bei erhöhten Zuverlässigkeitsanforderungen folgender weiterer Schritt ausgeführt wird:
(k) Wechseln der Gerätefunktion nach Ablauf eines in beiden Isolationsüberwachungsgeräten (10) synchron laufenden Timers.

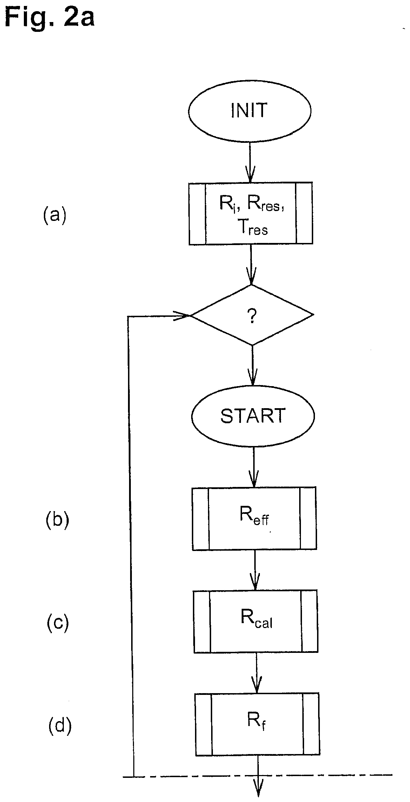

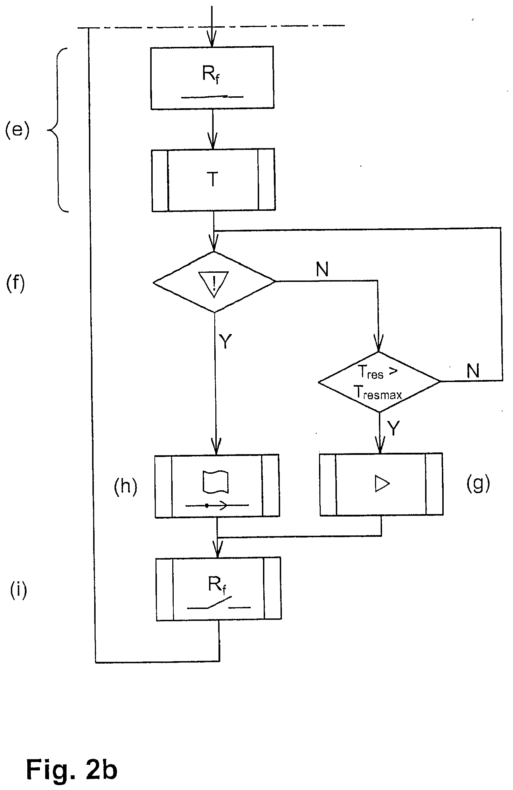

Die **Fig. 2a** und **2b** zeigen ein Ablaufdiagramm des zweiten erfindungsgemäßen Verfahrens, bei dem im Gegensatz zu dem ersten Verfahren keine direkte Datenübertragung zwischen dem zu überprüfenden Isolationsüberwachungsgerät 10 (Fig. 3a bis 3c) und der das Isolationsüberwachungsgerät kontrollierenden Prüfvorrichtung 20 (Fig. 3a bis 3c) stattfindet.

Im Einzelnen erfolgt zunächst in einem Initialisierungsschritt
(a) ein Hinterlegen eines Innenwiderstandswertes Ri des Isolationsüberwachungsgeräts 10, eines in dem Isolationsüberwachungsgerät 10 eingestellten Ansprechwertes Rres und einer in dem Isolationsüberwachungsgerät 10 eingestellten maximal zulässigen Ansprechzeit Tresmax in der Prüfvorrichtung 20,
   daran schließen sich, falls die Überprüfung des Isolationsüberwachungsgerätes ausgeführt werden soll, in einem kontinuierlich ablaufenden Prüfungszyklus die folgenden Verfahrensschritte an:
(b) Messen eines wirksamen Isolationswiderstands Reff, der sich ergibt aus dem Innenwiderstand Ri des aktiven Isolationsüberwachungsgeräts und einem parallel dazu liegenden Isolationswiderstand Riso des ungeerdeten Stromversorgungssystems, durch die Prüfvorrichtung,
(c) Berechnen eines Isolationswiderstandswertes Rcal des ungeerdeten Stromversorgungssystems aus dem gemessenen wirksamen Isolationswiderstandswert Reff und dem hinterlegten Innenwiderstandswert Ri des Isolationsüberwachungsgeräts durch die Prüfvorrichtung,
(d) Berechnen eines kritischen Prüf-Fehlerwiderstandswertes Rf unter Berücksichtigung des berechneten Isolationswiderstandswertes Rcal des ungeerdeten Stromversorgungssystems durch die Prüfvorrichtung 20,
(e) Zuschalten des Prüf-Fehlerwiderstands Rf zwischen mindestens einen der aktiven Leiter des ungeerdeten Stromversorgungssystems und Erde durch die Prüfvorrichtung und gleichzeitiges Starten einer Zeitmesseinrichtung in der Prüfvorrichtung 20 zur Messung einer Ansprechzeit Tres des Isolationsüberwachungsgerätes 10,
(f) Überwachen eines System-Alarmausgangs des Isolationsüberwachungsgerätes und Messen der Ansprechzeit Tres durch die Prüfvorrichtung,
(g) Starten einer Fehlerbehandlung durch die Prüfvorrichtung, falls die gemessene Ansprechzeit Tres die maximal zulässige Ansprechzeit Tresmax überschreitet,
(h) Erstellen eines Ergebnisprotokolls und/oder Übertragen des Prüfungsergebnisses an ein Leitsystem, falls die gemessene Ansprechzeit Tres die maximal zulässige Ansprechzeit Tresmax nicht überschreitet, also eine funktionsgemäße Alarmauslösung erfolgt ist,
(i) Wegschalten des Prüf-Fehlerwiderstands Rf durch die Prüfvorrichtung 20.

Die **Fig.3a** bis **3c** zeigen verschiedene Möglichkeiten der Entkopplung des System-Alarmausgangs 12 des Isolationsüberwachungsgerätes 10, um sicherstellen zu können, dass der von dem Isolationsüberwachungsgerät 10 ausgelöste Systemalarm nur wirksam wird, falls dieser ausgelöste Systemalarm nicht durch einen Prüfzyklus bewirkt wurde.

Dazu weist die Prüfvorrichtung 20 in einen Überwachungseingang 22 zum Überwachen des System-Alarmausgangs 12 des Isolationsüberwachungsgerätes 10 auf.

In einer ersten Ausführung gemäß **Fig. 3a** sind das Isolationsüberwachungsgerät 10 über seinen System-Alarmausgang 12 mit der Prüfvorrichtung 20 über dessen Überwachungseingang 22 seriell mit einander verbunden. Eine an dem System-Alarmausgang 12 des Isolationsüberwachungsgerätes 10 anstehende Alarmmeldung wird von der Prüfvorrichtung 20 nur dann als wirksamer Systemalarm weitergegeben, wenn diese Alarmmeldung nicht als Reaktion im Rahmen einer Funktionsprüfung ausgelöst wurde.

In der Ausführung gemäß **Fig. 3b** sind Alarmkontakte des System-Alarmausgangs 12 des Isolationsüberwachungsgerätes 10 in Reihe mit Alarmkontakten 24 der Prüfvorrichtung geschaltet, so dass ein geöffneter Alarmkontakt 24 der Prüfvorrichtung 20 eine durch Schließen eines "normally open" Alarmkontaktes 12 bewirkte Systemalarmmeldung des Isolationsüberwachungsgerätes 10 unterdrücken kann.

In der Ausführung gemäß **Fig. 3c** sind die Alarmkontakte des System-Alarmausgangs 12 des Isolationsüberwachungsgerätes 10 parallel zu den Alarmkontakten 24 der Prüfvorrichtung geschaltet, so dass ein geschlossener Alarmkontakt 24 der Prüfvorrichtung 20 eine durch Öffnen eines "normally closed" Alarmkontaktes 12 bewirkte Systemalarmmeldung des Isolationsüberwachungsgerätes 10 unterdrücken kann.

## Patentansprüche

1. Verfahren zur Funktionsprüfung eines in einem ungeerdeten Stromversorgungssystem installierten, normgerechten Isolationsüberwachungsgerätes (10) während des Betriebs, das Verfahren umfassend einen vollautomatisiert, kontinuierlich ablaufenden Prüfungszyklus umfassend die Verfahrensschritte
- (a) Messen eines ersten Isolationswiderstands (Riso1) des ungeerdeten Stromversorgungssystems durch das Isolationsüberwachungsgerät (10),
- (b) Übermitteln des ersten Isolationswiderstandswertes (Riso1) an eine Prüfvorrichtung (20) und Speichern des ersten Isolationswiderstandswertes (Riso1) in der Prüfvorrichtung (20),
- (c) Berechnen eines unkritischen Prüf-Fehlerwiderstandswertes (Rf) durch die Prüfvorrichtung,
- (d) Zuschalten des Prüf-Fehlerwiderstands (Rf) zwischen mindestens einen der aktiven Leiter des ungeerdeten Stromversorgungssystems und Erde durch die Prüfvorrichtung (20),
- (e) Messen eines zweiten Isolationswiderstands (Riso2) des ungeerdeten Stromversorgungssystems, der sich ergibt aus dem ersten Isolationswiderstand (Riso1) und dem parallel zugeschalteten Prüf-Fehlerwiderstand (Rf), durch das Isolationsüberwachungsgerät (10),
- (f) Übermitteln des zweiten Isolationswiderstandswertes (Riso2) an die Prüfvorrichtung (20) und Speichern des zweiten Isolationswiderstandswertes in der Prüfvorrichtung (20),
- (g) Berechnen eines Vergleichs-Isolationswiderstandswertes (Rref) aus dem ersten Isolationswiderstandswert (Riso1) und dem parallel zugeschalteten Prüf-Fehlerwiderstandswert (Rf) durch die Prüfvorrichtung (20),
- (h) Vergleichen des durch das Isolationsüberwachungsgerät (10) gemessenen zweiten Isolationswiderstands (Riso2) mit dem durch die Prüfvorrichtung (20) berechneten Vergleichs-Isolationswiderstandswert (Rref) in der Prüfvorrichtung (20) und Erstellen eines Ergebnisprotokolls,
- (i) Aktivieren einer Alarmmeldung durch die Prüfvorrichtung (20), falls der Vergleich ergibt, dass der von dem Isolationsüberwachungsgerät (10) gemessene zweite Isolationswiderstand (Riso2) eine Abweichung von dem berechneten Vergleichs-Isolationswiderstandswert (Rref) aufweist, die auf eine Fehlfunktion des Isolationsüberwachungsgerätes (10) schließen lässt,
- (j) Wegschalten des Prüf-Fehlerwiderstands (Rf) durch die Prüfvorrichtung (20).

2. Verfahren nach Anspruch 1,
**dadurch gekennzeichnet,**
**dass**, wobei die Prüfvorrichtung (20) funktionaler Bestandteil eines weiteren Isolationsüberwachungsgerätes (10) ist, dieses weitere Isolationsüberwachungsgerät (10) bei Auftreten einer Fehlfunktion des bereits installierten Isolationsüberwachungsgerätes (10) die Aufgabe der Isolationsüberwachung in dem ungeerdeten Stromversorgungssystem übernimmt.

3. Verfahren nach Anspruch 1 oder 2,
**dadurch gekennzeichnet,**
**dass**, wobei die Prüfvorrichtung (20) funktionaler Bestandteil eines weiteren Isolationsüberwachungsgerätes (10) ist und das bereits installierte Isolationsüberwachungsgerät (10) eine weitere Prüfvorrichtung als funktionalen Bestandteil umfasst, das bereits installierte Isolationsüberwachungsgerät (10) und das weitere Isolationsüberwachungsgerät (10) wechselweise die Aufgabe der Isolationsüberwachung und die Aufgabe der Funktionsprüfung des jeweils anderen Isolationsüberwachungsgerätes (10) übernehmen.

4. Verfahren zur Funktionsprüfung eines in einem ungeerdeten Stromversorgungssystem installierten, normgerechten Isolationsüberwachungsgerätes (10) während des Betriebs, das Verfahren umfassend
- (a) Hinterlegen eines Innenwiderstandswertes (Ri) des Isolationsüberwachungsgeräts (10), eines in dem Isolationsüberwachungsgerät (10) eingestellten Ansprechwertes (Rres) und einer in dem Isolationsüberwachungsgerät (10) eingestellten maximal zulässigen Ansprechzeit (Tresmax) in einer Prüfvorrichtung (20), und das Verfahren umfassend einen vollautomatisiert, kontinuierlich ablaufenden Prüfungszyklus umfassend die Verfahrensschritte
- (b) Messen eines wirksamen Isolationswiderstands (Reff), der sich ergibt aus dem Innenwiderstand (Ri) des aktiven Isolationsüberwachungsgeräts (10) und einem parallel dazu liegenden Isolationswiderstand (Riso) des ungeerdeten Stromversorgungssystems, durch die Prüfvorrichtung (20)
- (c) Berechnen eines Isolationswiderstandswertes (Rcal) des ungeerdeten Stromversorgungssystems aus dem gemessenen wirksamen Isolationswiderstandswert (Reff) und dem hinterlegten Innenwiderstandswert (Ri) des Isolationsüberwachungsgeräts (10) durch die Prüfvorrichtung (20),
- (d) Berechnen eines kritischen Prüf-Fehlerwiderstandswertes Rf unter Berücksichtigung des berechneten Isolationswiderstandswertes (Rcal) des ungeerdeten Stromversorgungssystems durch die Prüfvorrichtung (20),
- (e) Zuschalten des Prüf-Fehlerwiderstands (Rf) zwischen mindestens einen der aktiven Leiter des ungeerdeten Stromversorgungssystems und Erde durch die Prüfvorrichtung (20) und gleichzeitiges Starten einer Zeitmesseinrichtung in der Prüfvorrichtung (20) zur Messung einer Ansprechzeit (Tres) des Isolationsüberwachungsgerätes (10),
- (f) Überwachen eines System-Alarmausgangs (12) des Isolationsüberwachungsgerätes (10) und Messen der Ansprechzeit (Tres) durch die Prüfvorrichtung (20),
- (g) Starten einer Fehlerbehandlung durch die Prüfvorrichtung (20), falls die gemessene Ansprechzeit (Tres) die maximal zulässige Ansprechzeit (Tresmax) überschreitet,
- (h) Erstellen eines Ergebnisprotokolls und/oder Übertragen des Prüfungsergebnisses an ein Leitsystem, falls die gemessene Ansprechzeit (Tres) die maximal zulässige Ansprechzeit (Tresmax) nicht überschreitet,
- (i) Wegschalten des Prüf-Fehlerwiderstands Rf durch die Prüfvorrichtung (20).

5. Verfahren nach Anspruch 4,
**dadurch gekennzeichnet,**
**dass** als Fehlerbehandlung eine oder mehrere der folgenden Aktionen durch die Prüfvorrichtung (20) ausgeführt werden: Protokollieren des Fehlers, Übermitteln einer Fehlermeldung an ein übergeordnetes Leitsystem, Ausgeben einer Funktions-Alarmmeldung , Abschalten des Stromversorgungssystems.

6. Verfahren nach Anspruch 4 oder 5,
**dadurch gekennzeichnet,**
**dass** zur Bereitstellung eines wirksamen Systemalarms eine Unterscheidung zwischen einem tatsächlichem Systemalarm des Isolationsüberwachungsgerätes (10) und einem prüfungsbedingten Systemalarm des Isolationsüberwachungsgerätes (10) durch eine Entkopplung des System-Alarmausgangs (12) des Isolationsüberwachungsgerätes in der Weise erfolgt, dass der von dem Isolationsüberwachungsgerät (10) ausgelöste Systemalarm nur wirksam wird, falls der von dem Isolationsüberwachungsgerät (10) ausgelöste Systemalarm nicht durch einen Prüfzyklus bewirkt wurde.

7. Prüfvorrichtung (20) zur Funktionsprüfung eines in einem ungeerdeten Stromversorgungssystem installierten, normgerechten Isolationsüberwachungsgerätes (10) während des Betriebs, welche eingerichtet ist, ein Verfahren nach einem der Ansprüche 1 bis 3 auszuführen, die Prüfvorrichtung (20) umfassend eine Steuer- und Recheneinheit mit einer Speichereinrichtung zum Ausführen des vollautomatisiert, kontinuierlich ablaufenden Prüfungszyklus, eine Kommunikationseinrichtung zur Datenübertragung, eine Schalteinrichtung zum Schalten des Prüf-Fehlerwiderstands (Rf) zwischen mindestens einen aktiven Leiter des ungeerdeten Stromversorgungssystems und Erde und eine Prüfalarmeinrichtung.

8. Prüfvorrichtung (20) zur Funktionsprüfung eines in einem ungeerdeten Stromversorgungssystem installierten, normgerechten Isolationsüberwachungsgerätes (10) während des Betriebs, welche eingerichtet ist, ein Verfahren nach einem der Ansprüche 4 bis 6 auszuführen, die Prüfvorrichtung (20) umfassend eine Steuer- und Recheneinheit mit einer Speichereinrichtung zum Ausführen des vollautomatisiert, kontinuierlich ablaufenden Prüfungszyklus, eine Messeinrichtung zum Messen des in dem ungeerdeten Stromversorgungssystem wirksamen Isolationswiderstands (Reff), eine Kommunikationseinrichtung zur Datenübertragung, eine Schalteinrichtung zum Schalten des Prüf-Fehlerwiderstands (Rf) zwischen mindestens einen aktiven Leiter des ungeerdeten Stromversorgungssystem und Erde und einen Überwachungseingang (22) zum Überwachen eines System-Alarmausgangs (12) des Isolationsüberwachungsgerätes.

9. Isolationsüberwachungsgerät (10) zur Überwachung eines Isolationswiderstands eines ungeerdeten Stromversorgungssystems,
**gekennzeichnet durch**
eine Prüfvorrichtung (20) nach Anspruch 7.

10. Isolationsüberwachungsgerät (10) zur Überwachung eines Isolationswiderstands eines ungeerdeten Stromversorgungssystems,
**gekennzeichnet durch**
eine Prüfvorrichtung (20) nach Anspruch 8.

## Claims

1. A method for testing the function of a standard insulation monitoring device (10), installed in an ungrounded power supply system, during operation
said method comprising
a fully automated, perpetually running testing cycle, comprising the method steps:
- (a) measuring a first insulation resistance (Riso1) of the ungrounded power supply system via the insulation monitoring device (10),
- (b) transmitting the first insulation resistance value (Riso1) to a testing apparatus (20) and saving the first insulation resistance value (Riso1) in the testing apparatus (20),
- (c) calculating an uncritical test fault resistance value (Rf) via the testing apparatus,
- (d) adding the test fault resistance (Rf) between at least one of the active conductors of the ungrounded power supply system and ground via the testing apparatus (20),
- (e) measuring a second insulation resistance (Riso2) of the ungrounded power supply system via the insulation monitoring device (10), said second insulation resistance (Riso2) resulting from the first insulation resistance (Riso1) and the test fault resistance (Rf) added parallel thereto,
- (f) transmitting the second insulation fault resistance (Riso2) to the testing apparatus (20) and saving the second insulation fault resistance in the testing apparatus (20),
- (g) calculating a comparative insulation fault value (Rref), via the testing apparatus (20), from the first insulation resistance value (Riso1) and the test fault resistance value (Rf) added parallel thereto,
- (h) comparing the second insulation resistance (Riso2) measured by the insulation monitoring device (10) to the comparative insulation resistance value (Rref) calculated by the testing apparatus (20) in the testing apparatus (20) and generating a result log,
- (i) activating an alarm message via the testing apparatus (20), should the comparison result in the second insulation resistance (Riso2) measured by the insulation monitoring device (10) deviating from the calculated comparative insulation resistance value (Rref), said deviation indicating a faulty function of the insulation monitoring device (10),
- (j) removing the test fault resistance (Rf) via the testing apparatus (20).

2. The method according to claim 1,
**characterized in that**
wherein the testing apparatus (20) is a functional component of a further insulation monitoring device (10), this insulation monitoring device (10) takes over the task of insulation monitoring in the ungrounded power supply system when a faulty function occurs in the already installed insulation monitoring device (10).

3. The method according to claim 1 or 2,
**characterized in that**
wherein the testing apparatus (20) is a functional component of a further insulation monitoring device (10) and the already installed insulation monitoring device (10) comprises a further testing apparatus as a functional component, the already installed insulation monitoring device (10) and the further insulation monitoring device (10) alternately take over the task of monitoring the insulation and the task of testing the function of the other insulation monitoring device (10).

4. A method for testing the function of a standard insulation monitoring device (10), installed in an ungrounded power supply system, during operation,
said method comprising
- (a) depositing the following in the testing apparatus (20): an internal resistance value (Ri) of the insulation monitoring device (10), a response value (Rres) set in the insulation monitoring device (10) and a maximum permissible response time (Tresmax) set in the insulation monitoring device (10),
and said method comprising a fully automated, perpetually running testing cycle, comprising the method steps:
- (b) measuring an effective insulation resistance (Reff) via the testing apparatus (20), said effective insulation resistance (Reff) resulting from the internal resistance (Ri) of the active insulation monitoring device (10) and an insulation resistance (Riso) of the ungrounded power supply system arranged parallel thereto
- (c) calculating an insulation resistance value (Rcal) of the ungrounded power supply system via the testing apparatus (20) from the measured effective insulation resistance value (Reff) and the deposited internal resistance value (Ri) of the insulation monitoring device (10),
- (d) calculating a critical test fault resistance value Rf via the testing apparatus (20) while considering the calculated insulation resistance value (Rcal) of the ungrounded power supply system,
- (e) adding the test fault resistance (Rf) between at least one of the active conductors of the ungrounded power supply system and ground via the testing apparatus (20) and simultaneously starting a time measuring device in the testing apparatus (20) for measuring a response time (Tres) of the insulation monitoring device (10),
- (f) monitoring a system alarm output (12) of the insulation monitoring device (10) and measuring the response time (Tres) via the testing apparatus (20),
- (g) starting a fault treatment via the testing apparatus (20), should the measured response time (Tres) exceed the maximum permissible response time (Tresmax),
- (h) generating a result log and/or transmitting the test results to a management system, should the measured response time (Tres) not exceed the maximum permissible response time (Tresmax),
- (i) removing the test fault resistance Rf via the testing apparatus (20).

5. The method according to claim 4,
**characterized in that**
one or more of the following actions can be executed by the testing apparatus (20) as a fault treatment: logging the fault; transmitting a fault message to a superordinate management system; dispatching a function alarm message; shutting down the power supply system.

6. The method according to claim 4 or 5,
**characterized in that**
by uncoupling the system alarm output (12) of the insulation monitoring device for providing an effective system alarm, a difference is made between an actual system alarm of the insulation monitoring device (10) and a test-related system alarm of the insulation monitoring device (10) in such a manner that the system alarm triggered by the insulation monitoring device (10) only becomes effective if the system alarm triggered by the insulation monitoring device (10) was not triggered by a testing cycle.

7. A testing apparatus (20) for testing the function of a standard insulation monitoring device (10), installed in an ungrounded power supply system, during operation, said testing device (20) being configured for implementing a method according to any one of the claims 1 to 3 and comprising:
a controlling and a computing unit having a storage device for implementing the fully automated, perpetually running testing cycle;
a communication device for transmitting data; a switching device for adding the test fault resistance (Rf) between at least one active conductor of the ungrounded power supply system and ground; and a test alarm device.

8. A testing apparatus (20) for testing the function of a standard insulation monitoring device (10), installed in an ungrounded power supply system, during operation, said testing apparatus (20) being configured for implementing a method according to any one of the claims 4 to 6 and comprising:
a controlling and computing unit having a storage device for implementing the fully automated, perpetually running testing cycle;
a measuring device for measuring the insulation resistance (Reff) effective in the ungrounded power supply system; a communication device for transmitting data; a switching device for adding the test fault resistance (Rf) between at least one active conductor of the ungrounded power supply system and ground; and a monitoring input (22) for monitoring a system alarm output (12) of the insulation monitoring device.

9. An insulation monitoring device (10) for monitoring an insulation resistance of an ungrounded power supply system,
**characterized by**
a testing apparatus (20) according to claim 7.

10. An insulation monitoring device (10) for monitoring an insulation resistance of an ungrounded power supply system,
**characterized by**
a testing apparatus (20) according to claim 8.

## Revendications

1. Procédé pour l'essai fonctionnel d'un dispositif de surveillance d'isolation (10), qui est adapté aux normes et installé dans un système d'alimentation en courant non mis à la terre, pendant l'opération
ledit procédé comprenant
un cycle d'essai complètement automatique, courant en permanence et comprenant les étapes de procédé suivants :
- (a) la mesure d'une première résistance d'isolation (Riso1) de la système d'alimentation en courant non mis à la terre par le dispositif de surveillance d'isolation (10),
- (b) la transmission de la première valeur de résistance d'isolation (Riso1) à un appareil d'essai (20) et le stockage de la première valeur de résistance d'isolation (Riso1) dans l'appareil d'essai (20),
- (c) le calcul d'une valeur de résistance de défaut d'essai (Rf) pas grave par l'appareil d'essai,
- (d) l'intégration de la résistance de défaut d'essai (Rf) entre au moins un de conducteurs actifs du système d'alimentation en courant non mis à la terre et la terre par l'appareil d'essai (20),
- (e) la mesure d'une deuxième résistance d'isolation (Riso2) du système d'alimentation en courant non mis à la terre par le dispositif de surveillance d'isolation (10), ladite deuxième résistance d'isolation (Riso2) étant le résultat de la première résistance d'isolation (Riso1) et la résistance de défaut d'essai (Rf) intégrée parallèlement,
- (f) la transmission de la deuxième résistance de défaut d'isolation (Riso2) à l'appareil d'essai (20) et le stockage de la deuxième valeur de résistance d'isolation dans l'appareil d'essai (20),
- (g) le calcul d'une valeur de résistance d'isolation comparative (Rref) basé sur la première valeur de résistance d'isolation (Riso1) et la valeur de résistance de défaut d'essai (Rf) intégrée parallèlement par l'appareil d'essai (20),
- (h) la comparaison de la deuxième résistance d'isolation (Riso2) mesurée par le dispositif de surveillance d'isolation (10) à la valeur de résistance d'isolation comparative (Rref), qui est calculée par l'appareil d'essai (20), dans l'appareil d'essai (20) et la génération d'un rapport de résultats,
- (i) le déclenchement d'une alarme par l'appareil d'essai (20) si la comparaison donne que la deuxième résistance d'isolation (Riso2) mesurée par le dispositif de surveillance d'isolation (10) est différente de la valeur de résistance d'isolation comparative (Rref) calculée, ladite différence indiquant un fonctionnement incorrect du dispositif de surveillance d'isolation (10),
- (j) l'élimination de la résistance de défaut d'essai (Rf) par l'appareil d'essai (20).

2. Procédé selon la revendication 1,
**caractérisé en ce que**
l'appareil d'essai (20) étant un composant fonctionnel d'un outre dispositif de surveillance d'isolation (10), ce dispositif de surveillance d'isolation (10) assume la tâche de surveillance d'isolation dans le système d'alimentation en courant non mis à la terre quand un fonctionnement incorrect du dispositif de surveillance d'isolation (10) déjà installé se produit.

3. Procédé selon la revendication 1 ou 2,
**caractérisé en ce que**
l'appareil d'essai (20) étant un composant fonctionnel d'un outre dispositif de surveillance d'isolation (10) et le dispositif de surveillance d'isolation (10) déjà installé comprenant un outre appareil d'essai comme composant fonctionnel, le dispositif de surveillance d'isolation (10) déjà installé et l'outre dispositif de surveillance d'isolation (10) assument alternativement la tâche de surveillance d'isolation et la tâche d'essai de fonction de l'autre dispositif de surveillance d'isolation (10).

4. Procédé pour l'essai fonctionnel d'un dispositif de surveillance d'isolation (10), qui est adapté aux normes et installé dans un système d'alimentation en courant non mis à la terre, pendant l'opération,
ledit procédé comprenant
- (a) le dépôt des choses suivantes dans l'appareil d'essai (20): une valeur de résistance interne (Ri) du dispositif de surveillance d'isolation (10), une valeur de réponse (Rres) ajustée dans le dispositif de surveillance d'isolation (10) et un temps de réponse (Tresmax) permissible au maximum et ajusté dans le dispositif de surveillance d'isolation (10),
et ledit procédé comprenant un cycle d'essai complètement automatique, courant en permanence et comprenant les étapes de procédé suivantes :
- (b) la mesure d'une résistance d'isolation effective (Reff) par l'appareil d'essai (20), ladite résistance d'isolation effective (Reff) étant le résultat de la résistance interne (Ri) du dispositif de surveillance d'isolation (10) actif et une résistance d'isolation (Riso) disposée parallèlement du système d'alimentation en courant non mis à la terre,
- (c) le calcul d'une valeur de résistance d'isolation (Rcal) du système d'alimentation en courant non mis à la terre par l'appareil d'essai (20) basé sur la valeur de résistance d'isolation effective (Reff) mesurée et la valeur de résistance interne (Ri) déposée du dispositif de surveillance d'isolation (10),
- (d) le calcul d'une valeur de résistance de défaut d'essai Rf critique par l'appareil d'essai (20) en considérant la valeur de résistance d'isolation (Rcal) calculée du système d'alimentation en courant non mis à la terre,
- (e) l'intégration de la résistance de défaut d'essai (Rf) entre au moins un de conducteurs actifs du système d'alimentation en courant non mis à la terre et la terre par l'appareil d'essai (20) et le démarrage simultané d'un dispositif de comptage horaire dans l'appareil d'essai (20) pour mesurer un temps de réponse (Tres) du dispositif de surveillance d'isolation (10),
- (f) la surveillance d'une sortie d'alarme de système (12) du dispositif de surveillance d'isolation (10) et la mesure du temps de réponse (Tres) par l'appareil d'essai (20),
- (g) le démarrage d'une traitement de défaut par l'appareil d'essai (20) si le temps de réponse (Tres) mesuré dépasse le temps de réponse (Tresmax) permissible au maximum,
- (h) la génération d'un rapport de résultats et/ou la transmission du résultat d'essai à un système de guidage si le temps de réponse (Tres) mesuré ne dépasse pas le temps de réponse (Tresmax) permissible au maximum,
- (i) l'élimination de la résistance de défaut d'essai (Rf) par l'appareil d'essai (20).

5. Procédé selon la revendication 4,
**caractérisé en ce qu'**
un ou plusieurs d'actions suivantes peuvent être effectuées par l'appareil d'essai (20) comme traitement de défaut :
l'enregistrement du défaut, la transmission d'un avertissement de défaut à un système de guidage supérieur, la sortie d'une alarme fonctionnelle, le débranchement du système d'alimentation en courant.

6. Procédé selon la revendication 4 ou 5,
**caractérisé en ce que**
par un découplage de la sortie d'alarme de système (12) du dispositif de surveillance d'isolation pour prévoir une alarme de système effective, on établit une différence entre une vraie alarme de système du dispositif de surveillance d'isolation (10) et une alarme de système en relation des essais du dispositif de surveillance d'isolation (10) de telle manière que l'alarme de système déclenchée par le dispositif de surveillance d'isolation (10) devient effective seulement si l'alarme de système déclenchée par le dispositif de surveillance d'isolation (10) n'est pas déclenchée par un cycle d'essai.

7. Appareil d'essai (20) pour l'essai fonctionnel d'un dispositif de surveillance d'isolation (10), qui est adapté aux normes et installé dans un système d'alimentation en courant non mis à la terre, pendant l'opération, ledit appareil d'essai (20) étant configuré pour l'implémentation d'un procédé selon l'une quelconque des revendications 1 à 3 et comprenant :
une unité de contrôle et de computation ayant un dispositif de stockage pour l'implémentation du cycle d'essai complètement automatique et courant en permanence, un dispositif de communication pour la transmission de données, un dispositif de commutation pour intégrer la résistance de défaut d'essai (Rf) entre au moins un conducteur actif du système d'alimentation en courant non mis à la terre et la terre, et un dispositif d'alarme d'essai.

8. Appareil d'essai (20) pour l'essai fonctionnel d'un dispositif de surveillance d'isolation (10), qui est adapté aux normes et installé dans un système d'alimentation en courant non mis à la terre, pendant l'opération, ledit appareil d'essai (20) étant configuré pour l'implémentation d'un procédé selon l'une quelconque des revendications 4 à 6 et comprenant :
une unité de contrôle et de computation ayant un dispositif de stockage pour l'implémentation du cycle d'essai complètement automatique et courant en permanence, un dispositif de mesure pour la mesure de la résistance d'isolation (Reff) effective dans le système d'alimentation en courant non mis à la terre, un dispositif de communication pour la transmission de données, un dispositif de commutation pour l'intégration de la résistance de défaut d'essai (Rf) entre au moins un conducteur actif du système d'alimentation en courant non mis à la terre et la terre, et une entrée de surveillance (22) pour la surveillance d'une sortie d'alarme de système (12) du dispositif de surveillance d'isolation.

9. Dispositif de surveillance d'isolation (10) pour la surveillance d'une résistance d'isolation d'un système d'alimentation en courant non mis à la terre,
**caractérisé par**
un appareil d'essai (20) selon la revendication 7.

10. Dispositif de surveillance d'isolation (10) pour la surveillance d'une résistance d'isolation d'un système d'alimentation en courant non mis à la terre,
**caractérisé par**
un appareil d'essai (20) selon la revendication 8.
